# EUROPÄISCHE PATENTSCHRIFT

(11) **EP 1 878 059 B1**
(45) Veröffentlichungstag und Bekanntmachung des Hinweises auf die Patenterteilung: **11.10.2017**
(21) Anmeldenummer: 06708511.8
(22) Anmeldetag: 24.02.2006
(51) Int. Cl.: H01L 29/78, H01L 21/768

(54) **HALBLEITERANORDNUNG VON MOSFETS**
SEMICONDUCTOR ARRANGEMENT OF MOSFETS
SYSTEME A SEMICONDUCTEURS DE MOSFET

(30) Priorität: 25.04.2005 DE 102005019157
(43) Veröffentlichungstag der Anmeldung: 16.01.2008
(73) Patentinhaber: Robert Bosch GmbH, 70442 Stuttgart (DE)
(72) Erfinder: CHABAUD, Antoine, 70439 Stuttgart-Stammheim (DE)
(86) Internationale Anmeldenummer: PCT/EP2006/060268
(87) Internationale Veröffentlichungsnummer: WO 2006/114344

(56) Entgegenhaltungen:
- EP-A- 0 923 133
- US-A1- 2002 088 989

## Beschreibung

### Stand der Technik

Die Erfindung betrifft eine Anordnung von MOSFETs ("Metal Oxide Semiconductor Field-Effect Transistor") zur Steuerung von dergleichen mit mindestens einem ersten und einem zweiten MOSFET.

MOSFETs in integrierten Schaltungen sind etablierte Bauelemente in der Halbleitertechnologie. Dabei kann eine Unterscheidung bezüglich ihres Aufbaus zwischen horizontalen und vertikalen MOSFETs getroffen werden. So sind Aufbau und Funktionsweise von horizontalen MOSFETs aus beispielsweise DE 40 03 389 C2 und von vertikalen MOSFETs aus EP 0 671 056 B1 oder EP 0 594 177 B1 bekannt. Schaltungen mit horizontalen MOSFETs sind aus beispielsweise EP 0 923 133 A1 bekannt.

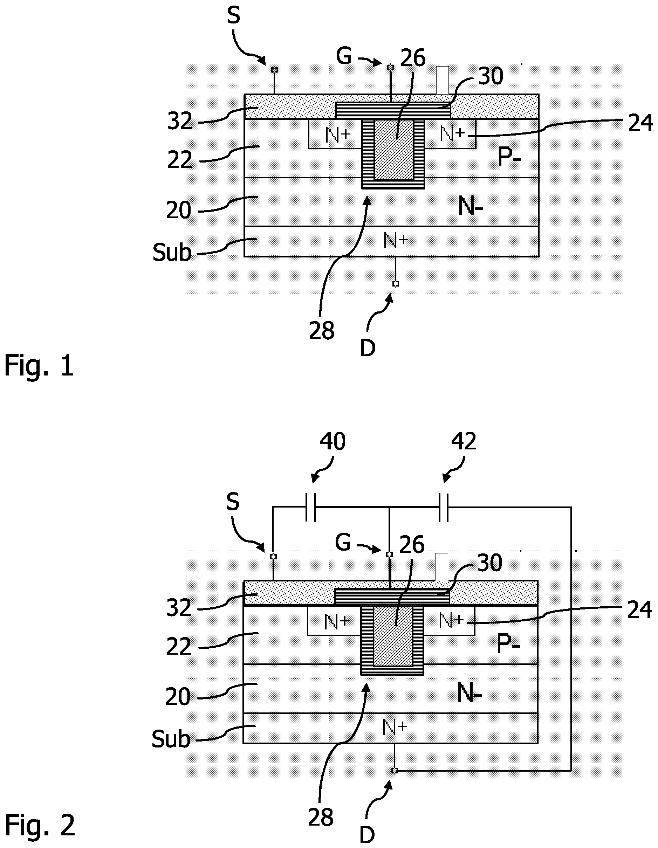

Vertikale MOSFETs weisen eine Grabenstruktur auf und bieten die Möglichkeit, viele Transistoren besonders raumsparend anzuordnen. Der Aufbau eines vertikalen N-Kanal-MOSFETs wird nun mit Hilfe der Fig. 1 kurz erläutert: Der MOSFET hat drei elektrische Kontaktbereiche, die bekanntermaßen Source- S, Gate- G und Drain-Anschluss D genannt werden. Typisch für einen vertikalen MOSFET ist, dass der Drain-Anschluss D nicht zusammen mit den beiden anderen Source- S und Gate-Anschlüssen G auf einer gleichen Seite eines Halbleitersubstrates angeordnet ist, welche als die Oberseite des Halbleitersubstrates betrachtet wird. Stattdessen ist der Drain-Anschluss D auf einer dann als Rückseite des Substrates zu bezeichnenden Seite angeordnet. Der Drain-Anschluss D kontaktiert daher direkt die unterste Schicht des Substrates, nämlich die Substratschicht Sub von einem ersten Leitfähigkeitstyp n, hier im Beispiel eine (N+)-Schicht. Auf dieser Substratschicht Sub ist ein Drain-Bereich 20 mit ebenfalls dem ersten Leitfähigkeitstyp n angeordnet, hier im Beispiel eine (N-)-Schicht. Das '+' Zeichen gibt eine hohe Dotierungskonzentration an, das '-' Zeichen entsprechend eine niedrige Dotierungskonzentration. Auf dem Drain-Bereich 20 ist ein Kanal-Bereich 22 von einem zweiten Leitfähigkeitstyp p angeordnet, hier eine (P-)-Schicht. Weiter ist ein Source-Bereich 24 mit dem ersten Leitfähigkeitstyp n ausgebildet, hier ein (N+)-Bereich. Eine Gate-Elektrode 26 füllt den inneren Bereich eines Grabens 28, der sich vom oberen Teil des Source-Bereiches 24 über die gesamte Schichtdicke des Kanal-Bereiches 22 hindurch bis hin zum oberen Teil des Drain-Bereiches 20 erstreckt. Elektrisch ist die Gate-Elektrode 26 vom umliegenden Bereichen getrennt durch eine Isolierung 30 aus typischerweise einem Oxid wie SiO₂. Schließlich ist eine Source-Elektrode 32 vorgesehen, die direkt mit dem Source-Bereich 24 verbunden ist.

Wird zwischen dem Source- S und Drain-Anschluss D eine Spannung angelegt, kann trotzdem kein Strom fließen, da zwischen den beiden Anschlüssen der Kanal-Bereich 22 mit dem (P-)-Typ, also ein Bereich mit vielen Löchern und sehr wenigen Elektronen, angeordnet ist. Der MOSFET befindet sich im Sperrzustand, d. h. er ist nicht leitfähig oder "selbstsperrend". Dieser Sperrzustand kann dadurch beseitigt werden, indem die elektrische Leitfähigkeit des Kanal-Bereiches 22 zwischen dem Source- S und Drain-Anschluss D durch Anlegen einer positiven Spannung am Gate-Anschluss G verändert wird. Die am Gate-Anschluss G beaufschlagte positive Spannung führt zu einer Anreicherung von Elektronen in einem Seitenbereich des Grabens 28 zwischen den Source- S und Drain-Bereichen D. Die von der positiven Gate-Elektrode 26 angezogenen Elektronen bilden als freie Ladungsträger einen leitfähigen n-Kanal in einem sonst nichtleitfähigen Kanal-Bereich 22, d. h. der MOSFET wird insgesamt in einen leitfähigen Zustand überführt. Eine Abnahme der positiven Gate-Spannung zu Null liefert wieder einen sperrenden MOSFET. Eine Steuerung des MOSFET-Zustandes ist durch die angelegte Gate-Spannung also im Prinzip möglich.

Wie bereits beschrieben, ist die Gate-Elektrode 26 umgeben von einer Isolierung 30. Dadurch ergeben sich zwei kapazitive Kopplungen am MOSFET. Wie in Figur 2 dargestellt, ergibt sich die erste parasitäre Kapazität 40 zwischen den Source- S und Gate-Anschlüssen G, die zweite parasitäre Kapazität 42 zwischen den Gate- G und Drain-Anschlüssen D. Sind diese Kapazitäten 40, 42 groß genug, führen sie dazu, dass elektrische Ladungen auf der Gate-Elektrode 26 gespeichert werden und auch bleiben, wenn einmal der Gate-Anschluss G mit einer Spannung beaufschlagt wurde. Um den MOSFET wieder auszuschalten, d. h. in einen sperrenden Zustand zu überführen, muss die Gate-Elektrode 26 entladen werden, damit die Gate-Source Spannung zu Null reduziert wird. Sonst bleibt der MOSFET im leitenden Zustand.

Es besteht daher ein Bedarf nach einer Lösung der Aufgabe, den Transistor jederzeit in einem sperrenden Zustand überführen zu können, auch bei einer fehlenden elektrischen Verbindung zwischen der Gate-Elektrode 26 und einer direkten Beschaltung des Transistors.

Vorteile der Erfindung Diese Aufgabe wird durch eine Anordnung gemäß Anspruch 1 gelöst. Die erfindungsgemäße Anordnung von MOSFETs hat den Vorteil, dass dadurch eine sichere Steuerung der MOSFETs ermöglicht wird. Ein schnelles Umschalten vom leitenden zu sperrenden Zustand der MOSFETs und umgekehrt ist jederzeit erreichbar. Da bei der Lösung auf eine direkte Verbindung zwischen der Gate-Elektrode 26 und einer Beschaltung des Transistors verzichtet wird, sind mögliche Gefahren wie Abrisse der Bonddrähte und Lötstellendefekte nicht gegeben.

Weiter ist es vorteilhaft, dass alle zur Anordnung nötigen MOSFETs auf einem Chip integrierbar sind. Zusätzlicher Platzbedarf an einer separaten Leiterplatte etwa ist daher nicht vorhanden. Auch sind weiter wie bisher nur drei Anschlüsse am Chip, an dem die MOSFETs angeordnet sind, notwendig. Eine Änderung des Gehäuses beispielsweise ist nicht vorgesehen. Zum einen wirkt dies in der Fertigung kostengünstig aus, zum anderen erleichtert die Lösung den Einbau, da kein großer zusätzlicher Aufwand entsteht.

Im übrigen wird auch die Stromfähigkeit des MOSFETs nicht stark beeinträchtigt, da zur Steuerung des MOSFETs nur wenige so genannte Zellen benötigt werden.

Vorteilhafte Weiterbildungen der Anordnung von MOSFETs sind in den Unteransprüchen angegeben und in der Beschreibung beschrieben.

### Zeichnung

Ausführungsbeispiele der Erfindung werden anhand der Zeichnung und der nachfolgenden Beschreibung näher erläutert. Es zeigen:
Figur 1 einen Aufbau eines vertikalen MOSFETs,
Figur 2 den Aufbau des MOSFETs mit den parasitären Kapazitäten,
Figur 3 eine Anordnung der MOSFETs auf einem Chip, und
Figur 4a und 4b jeweils einen Aufbau des MOSFETs mit einer metallischen Verbindung zwischen den Drain- D und Gate-Anschlüssen G.

### Beschreibung der Ausführungsbeispiele

Der Aufbau und die Funktionsweise eines vertikalen MOSFETs wurde bereits mit Hilfe der Fig. 1 erläutert. Es wurde auch die Problematik der parasitären Kapazitäten 40, 42 zwischen den Source- S und Gate-Anschlüssen G sowie zwischen den Gate- G und Drain-Anschlüssen D diskutiert, die aus der Isolierung 30 für die Gate-Elektrode G herrühren. Die parasitären Kapazitäten 40, 42 erlauben eine Aufladung der Gate-Elektrode 26, wenn der Gate-Anschluss G mit einer von außen angelegten Spannung beaufschlagt wird, oder diese Spannung durch äußere elektrische Felder entsteht. Durch diese Aufladung kann der MOSFET dauerhaft im leitfähigen Zustand verharren.

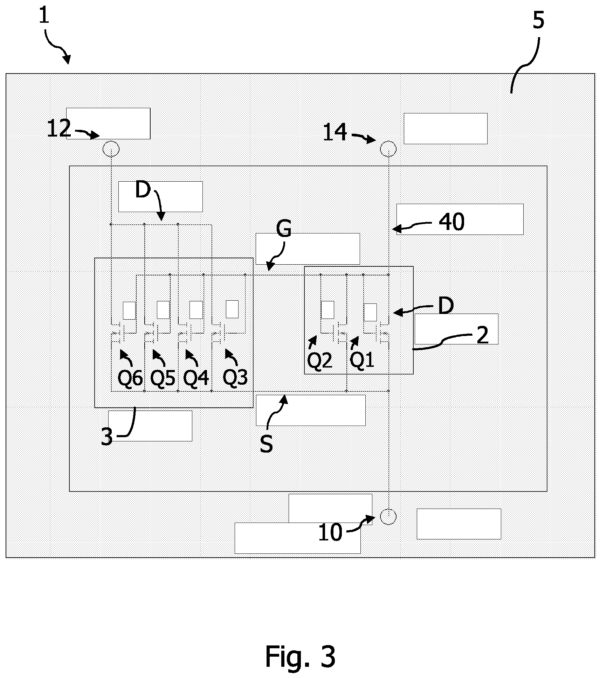

Es wird, wie in Fig. 3 zu erkennen, eine Anordnung 1 von mehreren MOSFETs ("Metal Oxide Semiconductor Field-Effect Transistor") auf einem einen ersten 10, einen zweiten 12 und einen dritten Anschluss 14 aufweisenden Chip (5) mit mindestens einem ersten, als Steuerungszelle 2 dienenden MOSFET Q1;Q2 und mindestens einem zweiten, als Leistungszelle 3 dienenden MOSFET Q3;Q4;Q5;Q6 mit jeweils einem Gate- G, Source- S und Drain-Anschluss D vorgeschlagen, wobei
- die Source-Anschlüsse S aller MOSFETs Q1;Q2;Q3;Q4;Q5;Q6 miteinander verbunden sind und den ersten Anschluss 10 des Chips 5 kontaktieren,
- der Drain-Anschluss D des mindestens einen, zweiten als Leistungszelle 3 dienenden MOSFETs Q3;Q4;Q5;Q6 den zweiten Anschluss 12 des Chips 5 kontaktiert,
- die Gate-Anschlüsse G aller MOSFETs Q1;Q2;Q3;Q4;Q5;Q6 miteinander verbunden sind und den dritten Anschluss 14 des Chips 5 kontaktieren, und
- Gate- G und Drain-Anschluss D des mindestens einen ersten, als Steuerungszelle dienenden MOSFETs Q1;Q2 miteinander verbunden sind.

Zur Kontaktierung mit dem dritten Anschluss 14 sind Steuerungsleitungen 40 vorgesehen. In dieser Anordnung ist eine sichere Steuerung des mindestens einen zweiten MOSFETs Q3;Q4;Q5;Q6 (Leistungszelle) durch den mindestens einen ersten MOSFET Q1;Q2 (Steuerungszelle) gewährleistet.

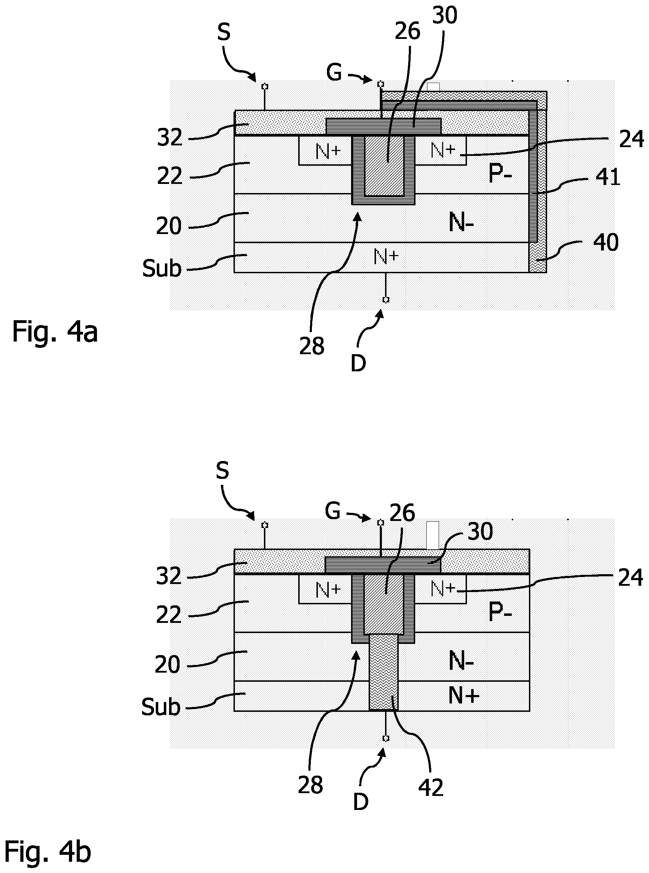

Es ist vorteilhaft, wenn Gate- G und Drain-Anschluss D des mindestens einen ersten MOSFETs Q1;Q2 miteinander durch mindestens eine metallische Verbindung 40, 42 verbunden sind (Fig. 4a, 4b). Bei Bedarf kann, wie in Fig. 4a dargestellt, ein Zwischenisolator 41 für die metallische Verbindung 40 vorgesehen sein.

Durch die beschriebene Anordnung der MOSFETs Q1;Q2;Q3;Q4;Q5;Q6 liegt ein Kurzschluss zwischen dem Drain- D und dem Gate-Anschluss G des mindestens einen ersten MOSFET Q1;Q2 vor. Diese Art der Schaltung entspricht der an sich bekannten Spiegelstromschaltung, beschrieben beispielsweise in DE 34 19 664 C2 oder EP 0 346 978 B1. Doch die Spiegelstromschaltung wird gemäß der Lehre in diesen Schriften mit bipolaren Transistoren aufgebaut, d. h. Feldeffekttransistoren sind nicht vorgesehen. Weiter ist aus DE 100 60 842 C2 eine Spiegelstromschaltung mit MOSFETs bekannt, doch es ist nicht vorgesehen, diese Anordnung auf einem Chip 5 mit drei Anschlüssen 10, 12, 14 vorzusehen und dabei die elektrischen Verbindungen der Anschlüsse gemäß Anspruch 1 auszubilden.

Denn die Spiegelstromschaltungen aus dem Stand der Technik werden nicht zur sicheren Steuerung bzw. Umschaltung von MOSFETs eingesetzt. Vielmehr wird in den oben zitierten Schriften beschrieben und bezweckt, mit der Spiegelstromschaltung in einem Ausgangszweig einen Strom zu erzeugen, der möglichst genau proportional einem Strom entspricht, der in einem Eingangszweig fließt. Damit wird also ein Stromfluss in seiner Stärke an eine andere Stelle in der Schaltung übertragen, d. h. gespiegelt. Die technische Motivation der Schaltung ist im Stand der Technik deutlich verschieden von der Motivation der vorliegenden Schrift.

Dass die vorgeschlagene Anordnung der MOSFETs eine sichere Abschaltung gewährleistet, wird durch folgende Überlegung erläutert: Zunächst sei der Fall angenommen, dass die Verbindung zwischen dem ersten Anschluss 10 des Chips 5 und einer externen Beschaltung fehlt oder unterbrochen ist. Dann gibt es keine Verbindung zwischen dem Chip 5 und der Masse, so dass im ganzen Chip 5 kein Strom fließt. Fehlt die Verbindung zwischen dem zweiten Anschluss 12 des Chips 5 und einer externen Beschaltung, dann fließt in den Leistungszellen kein Strom, daher kann keine Beschädigung der Transistoren auftreten. Eine Sperrung ist immer noch durch den dritten Anschluss 14 des Chips 5 möglich. Wird schließlich angenommen, dass die Verbindung zwischen dem dritten Anschluss 14 des Chips 5 und einer externen Beschaltung fehlt, dann werden die auf den Gate-Elektroden 26 gespeicherten Ladungen durch die Steuerungsleitungen 40 entladen, da diese noch leitend sind, solange die Spannungen am Gate-Anschluss G der Transistoren ausreichend hoch genug sind bzw. bleiben. Dies ist jedoch gewährleistet, solange genügend Ladungen auf den Gate-Elektroden 26 vorhanden sind. Da alle Transistoren die gleiche Spannung zwischen Gate- G und Source-Anschluss S und die gleiche Schwellenspannung besitzen, sperren nach Entladung der Kapazität 40 zwischen Gate- G und Source-Anschluss S alle Transistoren.

Zusammenfassend wird festgestellt, dass eine zuverlässige Steuerung bzw. Sperrung der MOSFETs in allen drei geschilderten Fällen erreicht wird.

Grundsätzlich ist eine Anwendung der vorgestellten Anordnung mit allen bekannten Arten von MOSFETs möglich. Bevorzugt sind jedoch vertikale MOSFETs. Neben selbstsperrenden MOSFETs (Anreicherungstyp) können auch selbstleitende MOSFETs (Verarmungstyp) eingesetzt werden.

Gemäß Fig. 3 ist bevorzugt, dass der mindestens eine erste MOSFET Q1,Q2 mit weiteren ersten MOSFETs Q2,Q1 parallel geschaltet ist zur Bildung von weiteren Steuerungszellen 2.

Ebenso ist bevorzugt, dass der mindestens eine zweite MOSFET Q3;Q4;Q5;Q6 mit weiteren zweiten MOSFETs Q4;Q5;Q6;Q3 parallel geschaltet ist zur Bildung von weiteren Leistungszellen 3.

## Patentansprüche

1. Anordnung (1) von mehreren MOSFETs
auf einem einen ersten (10), einen zweiten (12) und einen dritten Anschluss (14) aufweisenden Chip (5) mit mindestens einem ersten, als Steuerungszelle (2) dienenden MOSFET (Q1;Q2) und mindestens einem zweiten, als Leistungszelle (3) dienenden MOSFET (Q3;Q4;Q5;Q6) mit jeweils einem Gate- (G), Source- (S) und Drain-Anschluss (D), wobei
- die Source-Anschlüsse (S) aller MOSFETs (Q1;Q2;Q3;Q4;Q5;Q6) miteinander verbunden sind und den ersten Anschluss (10) des Chips (5) kontaktieren,
- der Drain-Anschluss (D) des mindestens einen zweiten, als Leistungszelle (3) dienenden MOSFETs (Q3;Q4;Q5;Q6) den zweiten Anschluss (12) des Chips (5) kontaktiert,
- die Gate-Anschlüsse (G) aller MOSFETs (Q1;Q2;Q3;Q4;Q5;Q6) miteinander verbunden sind und den dritten Anschluss (14) des Chips (5) kontaktieren, und
- Gate- (G) und Drain-Anschluss (D) des mindestens einen ersten, als Steuerungszelle dienenden MOSFETs (Q1;Q2) miteinander verbunden sind.

2. Anordnung (1) nach Anspruch 1,
**dadurch gekennzeichnet,**
**dass** Gate- (G) und Drain-Anschluss (D) des mindestens einen ersten MOSFETs (Q1;Q2) miteinander durch mindestens eine metallische Verbindung (40;42) verbunden sind.

3. Anordnung (1) nach Anspruch 2,
**dadurch gekennzeichnet,**
**dass** ein Zwischenisolator (41) für die metallische Verbindung (40) vorhanden ist.

4. Anordnung (1) nach einem der Ansprüche 1 bis 3, **dadurch gekennzeichnet,**
**dass** selbstsperrende MOSFETs (Q1;Q2;Q3;Q4;Q5;Q6) vorhanden sind.

5. Anordnung (1) nach einem der Ansprüche 1 bis 4, **dadurch gekennzeichnet,**
**dass** der mindestens eine erste MOSFET (Q1,Q2) mit weiteren ersten MOSFETs (Q2,Q1) parallel geschaltet ist zur Bildung von Steuerungszellen (2).

6. Anordnung (1) nach einem der Ansprüche 1 bis 5, **dadurch gekennzeichnet,**
**dass** der mindestens eine zweite MOSFET (Q3;Q4;Q5;Q6) mit weiteren zweiten MOSFETs (Q4;Q5;Q6;Q3) parallel geschaltet ist zur Bildung von Leistungszellen (3).

7. Anordnung (1) nach einem der Ansprüche 1 bis 6, **dadurch gekennzeichnet,**
**dass** vertikale MOSFETs (Q1;Q2;Q3;Q4;Q5;Q6) vorhanden sind.

## Claims

1. Arrangement (1) of a plurality of MOSFETs on a chip (5) having a first terminal (10), a second terminal (12) and a third terminal (14), comprising at least one first MOSFET (Q1;Q2) serving as control cell (2), and at least one second MOSFET (Q3;Q4;Q5;Q6) serving as power cell (3), each having a gate terminal (G), a source terminal (S) and a drain terminal (D), wherein
- the source terminals (S) of all the MOSFETs (Q1;Q2;Q3;Q4;Q5;Q6) are connected to one another and contact the first terminal (10) of the chip (5),
- the drain terminal (D) of the at least one second MOSFET (Q3;Q4;Q5;Q6) serving as power cell (3) contacts the second terminal (12) of the chip (5),
- the gate terminals (G) of all the MOSFETs (Q1;Q2;Q3;Q4;Q5;Q6) are connected to one another and contact the third terminal (14) of the chip (5), and
- gate terminal (G) and drain terminal (D) of the at least one first MOSFET (Q1;Q2) serving as control cell are connected to one another.

2. Arrangement (1) according to Claim 1, **characterized**
**in that** gate terminal (G) and drain terminal (D) of the at least one first MOSFET (Q1;Q2) are connected to one another by at least one metallic connection (40;42).

3. Arrangement (1) according to Claim 2, **characterized**
**in that** an intermediate insulator (41) for the metallic connection (40) is present.

4. Arrangement (1) according to any of Claims 1 to 3, **characterized**
**in that** normally off MOSFETs (Q1;Q2;Q3;Q4;Q5;Q6) are present.

5. Arrangement (1) according to any of Claims 1 to 4, **characterized**
**in that** the at least one first MOSFET (Q1,Q2) is connected in parallel with further first MOSFETs (Q2,Q1) in order to form control cells (2).

6. Arrangement (1) according to any of Claims 1 to 5, **characterized**
**in that** the at least one second MOSFET (Q3;Q4;Q5;Q6) is connected in parallel with further second MOSFETs (Q4;Q5;Q6;Q3) in order to form power cells (3).

7. Arrangement (1) according to any of Claims 1 to 6, **characterized**
**in that** vertical MOSFETs (Q1;Q2;Q3;Q4;Q5;Q6) are present.

## Revendications

1. Système (1) de plusieurs MOSFET sur une puce (5) présentant une première (10), une deuxième (12) et une troisième connexion (14), comportant au moins un premier MOSFET (Q1 ; Q2) servant de cellule de commande (2) et au moins un deuxième MOSFET (Q3 ; Q4 ; Q5 ; Q6) servant de cellule de puissance (3), présentant respectivement une connexion de grille (G), de source (S) et de drain (D), dans lequel
- les connexions de source (S) de tous les MOSFET (Q1 ; Q2 ; Q3 ; Q4 ; Q5 ; Q6) sont reliées les unes aux autres et viennent au contact de la première connexion (10) de la puce (5),
- la connexion de drain (D) du ou des deuxièmes MOSFET (Q3 ; Q4 ; Q5 ; Q6) servant de cellule de puissance (3) vient au contact de la deuxième connexion (12) de la puce (5),
- les connexions de grille (G) de tous les MOSFET (Q1 ; Q2 ; Q3 ; Q4 ; Q5 ; Q6) sont reliées les unes aux autres et viennent au contact de la troisième connexion (14) de la puce (5), et
- les connexions de grille (G) et de drain (D) du ou des premiers MOSFET (Q1 ; Q2) servant de cellule de commande sont reliées les unes aux autres.

2. Système (1) selon la revendication 1, **caractérisé en ce que** les connexions de grille (G) et de drain (D) du ou des premiers MOSFET (Q1 ; Q2) sont reliées les unes aux autres par l'intermédiaire d'au moins une liaison métallique (40 ; 42).

3. Système (1) selon la revendication 2, **caractérisé en ce qu'**un isolant intermédiaire (41) est présent pour la liaison métallique (40).

4. Système (1) selon l'une quelconque des revendications 1 à 3,
**caractérisé en ce que** des MOSFET autobloquants (Q1 ; Q2 ; Q3 ; Q4 ; Q5 ; Q6) sont présents.

5. Système (1) selon l'une quelconque des revendications 1 à 4,
**caractérisé en ce que** le ou les premiers MOSFET autobloquants (Q1, Q2) sont connectés en parallèle à d'autres premiers MOSFET (Q2, Q1) pour former des cellules de commande (2).

6. Système (1) selon l'une quelconque des revendications 1 à 5,
**caractérisé en ce que** le ou les deuxièmes MOSFET autobloquants (Q3 ; Q4 ; Q5 ; Q6) sont connectés en parallèle à d'autres deuxièmes MOSFET (Q4; Q5; Q6; Q3) pour former des cellules de puissance (3).

7. Système (1) selon l'une quelconque des revendications 1 à 6,
**caractérisé en ce que** des MOSFET verticaux (Q1 ; Q2 ; Q3 ; Q4 ; Q5 ; Q6) sont présents.
